# EUROPÄISCHE PATENTSCHRIFT

(11) **EP 3 966 933 B1**
(45) Veröffentlichungstag und Bekanntmachung des Hinweises auf die Patenterteilung: **02.10.2024**
(21) Anmeldenummer: 20723100.2
(22) Anmeldetag: 29.04.2020
(51) Int. Cl.: H03K 17/082, H03K 17/16

(54) **SCHUTZVORRICHTUNG UND ANSTEUERSCHALTUNG FÜR EINEN HALBLEITERSCHALTER UND VERFAHREN ZUM ANSTEUERN EINES HALBLEITERSCHALTERS**
PROTECTION DEVICE AND CONTROL CIRCUIT FOR A SEMI-CONDUCTOR SWITCH AND METHOD FOR CONTROLLING A SEMI-CONDUCTOR SWITCH
DISPOSITIF DE PROTECTION ET CIRCUIT DE COMMANDE DESTINÉS À UN COMMUTATEUR À SEMI-CONDUCTEUR ET PROCÉDÉ DE COMMANDE D'UN COMMUTATEUR À SEMI-CONDUCTEUR

(30) Priorität: 09.05.2019 DE 102019206688
(43) Veröffentlichungstag der Anmeldung: 16.03.2022
(73) Patentinhaber: Robert Bosch GmbH, 70442 Stuttgart (DE)
(72) Erfinder: RICHTER, Tobias, 74321 Bietigheim-Bissingen (DE); BRUCKHAUS, Tim, 71679 Asperg (DE); SINN, Peter, 74199 Untergruppenbach (DE)
(86) Internationale Anmeldenummer: PCT/EP2020/061902
(87) Internationale Veröffentlichungsnummer: WO 2020/225055

(56) Entgegenhaltungen:
- EP-A2- 0 730 331
- GB-A- 2 448 759
- US-A1- 2015 349 632
- US-A1- 2019 074 827

## Beschreibung

Die vorliegende Erfindung betrifft eine Schutzvorrichtung für einen Halbleiterschalter sowie eine Ansteuerschaltung für einen Halbleiterschalter. Ferner betrifft die vorliegende Erfindung ein Verfahren zum Ansteuern eines Halbleiterschalters. Insbesondere betrifft die vorliegende Erfindung den Schutz eines Halbleiterschalters vor Überspannungen.

### Stand der Technik

Die Verwendung von Halbleiterschaltern als Schaltelemente gewinnt zunehmend an Bedeutung. Dabei kann es beim Öffnen der Schaltelemente, insbesondere eines Halbleiterschaltelements, aufgrund von Streuinduktivitäten oder ähnlichem zu Überspannungen über den Ausgangsklemmen des Halbleiterschalters kommen. Um eine Beschädigung des Halbleiterschalters durch derartige Überspannungen zu vermeiden, ist ein geeigneter Überspannungsschutz vorzusehen. Ein solcher Überspannungsschutz ist beispielsweise unter dem Begriff "Active Clamping" bekannt.

Die Druckschriften US 2015/349632 A1 und GB 2 448 759 A offenbaren Schutzvorrichtungen und Ansteuerschaltungen für einen Halbleiterschalter.

Die Druckschrift DE 10 2013 202 641 A1 offenbart einen Überspannungsschutz für einen Halbleiterschalter mit einer statischen Komponente und einer dynamischen Komponente. Die dynamische Komponente kann zum Beispiel bei Überspannungen unter dem stationären Wert ansprechen und ist in ihrem Ansprechverhalten zeitlich begrenzt.

Für die Schutzvorrichtungen von Halbleiterschaltern können zur Detektion einer Überspannung beispielsweise Avalanche-Dioden eingesetzt werden. Mit steigenden Schaltgeschwindigkeiten der Halbleiterschalter müssen dabei zunehmend die kapazitiven Eigenschaften derartiger Avalanche-Dioden mitberücksichtigt werden.

### Offenbarung der Erfindung

Die vorliegende Erfindung schafft eine Schutzvorrichtung für einen Halbleiterschalter, eine Ansteuerschaltung für einen Halbleiterschalter und ein Verfahren zum Ansteuern eines Halbleiterschalters mit den Merkmalen der unabhängigen Patentansprüche. Weitere Ausführungsformen sind Gegenstand der abhängigen Patentansprüche.

Demgemäß ist vorgesehen:
Eine Schutzvorrichtung für einen Halbleiterschalter mit einem kapazitiven Bauelement, einem Integrator und einer Vergleichseinrichtung. Der Integrator ist dazu ausgelegt, einen Ladestrom in das kapazitive Bauelement zu integrieren. Auf diese Weise kann aus dem integrierten Ladestrom eine Ladungsmenge in dem kapazitiven Bauelement ermittelt werden. Das kapazitive Bauelement ist hierbei zwischen einem Eingangsanschluss des Halbleiterschalters und dem Integrator angeordnet. Die Vergleichseinrichtung ist dazu ausgelegt, den Halbleiterschalter anzusteuern, wenn die ermittelte Ladungsmenge in dem kapazitiven Bauelement einen vorgegebenen Grenzwert überschreitet.

Weiterhin ist vorgesehen:
Eine Ansteuerschaltung für einen Halbleiterschalter mit einer Treiberschaltung und einer erfindungsgemäßen Schutzvorrichtung für den Halbleiterschalter. Die Treiberschaltung ist dazu ausgelegt, ein Steuersignal für den Halbleiterschalter zu empfangen und einen Steueranschluss des Halbleiterschalters unter Verwendung des empfangenen Steuersignals anzusteuern. Die Treiberschaltung ist insbesondere mit der Schutzvorrichtung elektrisch gekoppelt. Die Treiberschaltung ist ferner dazu ausgelegt, den Halbleiterschalter zumindest teilweise anzusteuern, wenn die von der Schutzvorrichtung ermittelte Ladungsmenge in dem kapazitiven Bauelement den vorgegebenen Grenzwert überschreitet.

Schließlich ist vorgesehen:
Ein Verfahren zum Ansteuern eines Halbleiterschalters mit den Schritten des Integrierens eines Ladestroms in einem kapazitiven Bauelement, das zwischen einem Eingangsanschluss des Halbleiterschalters und einem Integrator angeordnet ist. Durch die Integration des Ladestroms wird somit eine Ladungsmenge in dem kapazitiven Bauelement ermittelt. Das Verfahren umfasst weiterhin einen Schritt zum Vergleichen der ermittelten Ladungsmenge in dem kapazitiven Bauelement mit einem vorgegebenen Grenzwert, und des Ansteuerns des Halbleiterschalters, wenn die ermittelte Ladungsmenge in dem kapazitiven Bauelement den vorgegebenen Grenzwert überschreitet.

### Vorteile der Erfindung

Konventionelle Überspannungsschutzeinrichtungen für Halbleiterschaltelemente verwenden in der Regel eine Clamping-Diode, beispielsweise eine Avalanche- oder Zener-Diode. Mit steigenden Schaltgeschwindigkeiten müssen hierbei auch die kapazitiven Eigenschaften, insbesondere die Sperrschichtkapazitäten derartiger Dioden mitberücksichtigt werden. Je nach Auslegung können sich die kapazitiven Eigenschaften negativ auf die Ansprechspannung oder das Ansprechverhalten einer Überspannungsschutzvorrichtung für den Halbleiterschalter auswirken.

Es ist daher eine Idee der vorliegenden Erfindung, dieser Erkenntnis Rechnung zu tragen und eine Schutzvorrichtung für einen Halbleiterschalter vorzusehen, welche gezielt die kapazitiven Eigenschaften eines Bauelements zur Detektion von Überspannungen berücksichtigt. Auf diese Weise ist insbesondere auch bei höheren Schaltgeschwindigkeiten eine zuverlässige und rasche Detektion von Überspannungen an einem Halbleiterschaltelement möglich. Entsprechend können entstehende Überspannungen frühzeitig erkannt und geeignete Gegenmaßnahmen zum Ableiten der Überspannungen eingeleitet werden. Beispielsweise kann das Halbleiterschaltelement ganz oder teilweise geschlossen werden, um einen weiteren Anstieg der Spannung über den Anschlüssen des Halbleiterschaltelements entgegenzuwirken. Hierdurch kann eine Beschädigung des Halbleiterschaltelements oder zumindest eine vorzeitige Alterung aufgrund von Überspannungen oder ähnlichem verhindert werden.

Ist die Kapazität des kapazitiven Bauelements bekannt, so kann durch Integration des elektrischen Stroms in das kapazitive Bauelement die Ladungsmenge in dem kapazitiven Bauelement ermittelt werden. Aus dem Zusammenhang der Kapazität des kapazitiven Bauelements und der ermittelten Ladungsmenge lassen sich somit Rückschlüsse über die Spannung an dem Halbleiterschaltelement ziehen. Überschreitet die ermittelte Ladungsmenge in dem kapazitiven Bauelement eine Ladungsmenge, welche zu einer vorgegebenen Auslösespannung korrespondiert, so können geeignete Maßnahmen eingeleitet werden, um einem weiteren Spannungsanstieg an dem Halbleiterschaltelement entgegenzuwirken oder die elektrische Spannung über dem Halbleiterschaltelement herabzusetzen. Beispielsweise kann hierzu das Halbleiterschaltelement ganz oder teilweise angesteuert bzw. geschlossen werden.

Die Auswertung der Ladungsmenge in dem kapazitiven Bauelement ermöglicht hierbei eine rasche und effiziente Detektion von potentiellen Überspannungen an dem Halbleiterschaltelement, insbesondere bei hohen Schaltgeschwindigkeiten.

Gemäß einer Ausführungsform umfasst das kapazitive Bauelement eine Diode. Insbesondere kann das kapazitive Bauelement beispielsweise eine Avalanche-Diode oder eine Zener-Diode umfassen. Dioden mit einer definierten Durchbruchspannung, wie beispielsweise Avalanche- oder Zener-Dioden, ermöglichen die Detektion einer Überspannung auch bei einem langsamen oder statischen Spannungsanstieg. Bei höheren Schaltgeschwindigkeiten müssen jedoch darüber hinaus auch die kapazitiven Eigenschaften, wie beispielsweise die Sperrschichtkapazität der Dioden, mitberücksichtigt werden. Durch die Auswertung der Ladungsmenge in die Diode kann bereits das Erreichen einer kritischen Überspannung detektiert werden, bevor die Sperrschichtkapazität der Diode aufgeladen ist und die Diode zündet. Entsprechend kann sowohl bei langsamen als auch bei schnellen Schaltvorgängen ein zuverlässiger Überspannungsschutz gewährleistet werden.

Gemäß einer Ausführungsform ist die vorgegebene Ladungsmenge unter Verwendung einer Sperrschichtkapazität der Diode einstellbar. Beispielsweise kann die Sperrschichtkapazität auf Grundlage von Angaben in dem Datenblatt der entsprechenden Diode bestimmt werden. Darüber hinaus sind selbstverständlich auch beliebige andere Verfahren, insbesondere messtechnische Verfahren zum Ermitteln der Sperrschichtkapazität der jeweiligen Diode möglich. Durch die Berücksichtigung der Sperrschichtkapazität kann das Ansprechen der Schutzvorrichtung zum Schutz des Halbleiterschalters präzise eingestellt werden. Beispielsweise kann auf Grundlage der Sperrschichtkapazität und einer vorgegebenen Spannungsschwelle für die Schutzvorrichtung eine Ladungsmenge ermittelt, insbesondere berechnet werden, bei welcher die Schutzvorrichtung auslösen soll.

Gemäß einer Ausführungsform ist die Vergleichseinrichtung dazu ausgelegt, den Halbleiterschalter anzusteuern, wenn eine elektrische Spannung über der Diode eine Durchbruchspannung der Diode überschreitet. Insbesondere kann es sich bei der Durchbruchspannung um die Durchbruchspannung einer Avalanche-Diode oder eine Zener-Diode in Sperrrichtung handeln. Auf diese Weise wird der Halbleiterschalter auch dann angesteuert, wenn die vorgegebene Durchbruchspannung der Diode in Sperrrichtung überschritten wird, selbst wenn bis zu diesem Zeitpunkt die ermittelte Ladungsmenge den vorgegebenen Grenzwert noch nicht erreicht hat. Hierdurch kann die Zuverlässigkeit der Schutzfunktion noch weiter erhöht werden.

Gemäß einer Ausführungsform umfasst das kapazitive Bauelement einen Kondensator. Kondensatoren sind einfach zu realisierende und kostengünstige Bauelemente. Durch die Verwendung von Kondensatoren kann somit eine preiswerte, einfache und zuverlässige Schutzvorrichtung für einen Halbleiterschalter realisiert werden.

Gemäß einer Ausführungsform ist der Integrator dazu ausgelegt, die Integration des Ladestroms mit einem Steuersignal für den Halbleiterschalter zu synchronisieren. Beispielsweise kann der Integrator synchron zu den Steuersignalen für den Halbleiterschalter zurückgesetzt werden. Auf diese Weise kann eine Drift des Integrators während der Integration des Ladestroms vermieden werden.

Gemäß einer Ausführungsform ist der Integrator dazu ausgelegt, die Integration des Ladestroms jeweils neu zu starten, wenn der Halbleiterschalter geöffnet wird. Zum Start der Integration kann der Wert des Integrators jeweils zurückgesetzt werden. Auf diese Weise beginnt die Integration des Ladestroms jeweils bei einem definierten Wert von Null, wenn der Halbleiterschalter geöffnet wird und somit die elektrische Spannung über dem Halbleiterschalter ansteigt.

Gemäß einer Ausführungsform kann der Integrator einen Kondensator umfassen. Insbesondere kann der Integrator aus einem Kondensator oder einer Anordnung mit mehreren Kondensatoren bestehen. Kapazitive Bauelemente, insbesondere Kondensatoren ermöglichen eine besonders einfache Integration von Ladungsmengen. Dabei kann eine über den beiden Anschlüssen des Kondensators anliegende elektrische Spannung zu der Ladungsmenge in dem Kondensator korrespondieren.

Die obigen Ausgestaltungen und Weiterbildungen lassen sich, soweit sinnvoll, beliebig miteinander kombinieren. Weitere Ausgestaltungen, Weiterbildungen und Implementierungen der Erfindung umfassen auch nicht explizit genannte Kombinationen von zuvor oder im Folgenden bezüglich den Ausführungsbeispielen beschriebenen Merkmalen der Erfindung. Insbesondere wird der Fachmann dabei auch Einzelaspekte als Verbesserungen oder Ergänzungen zu den jeweiligen Grundformen der Erfindung hinzufügen.

### Kurze Beschreibung der Zeichnungen

Weitere Merkmale und Vorteile der vorliegenden Erfindung werden nachfolgend anhand der Figuren erläutert. Dabei zeigen:
- Figur 1:: eine schematische Darstellung eines Prinzipschaltbilds einer Ansteuerschaltung für einen Halbleiterschalter mit einer Schutzvorrichtung gemäß einer Ausführungsform;
- Figur 2:: eine schematische Darstellung eines Prinzipschaltbilds einer Ansteuerschaltung für einen Halbleiterschalter gemäß einer weiteren Ausführungsform;
- Figur 3:: eine schematische Darstellung eines Prinzipschaltbilds einer Ansteuerschaltung für einen Halbleiterschalter gemäß noch einer weiteren Ausführungsform; und
- Figur 4:: eine schematische Darstellung eines Ablaufdiagramms, wie es einem Verfahren zum Ansteuern eines Halbleiterschalters gemäß einer Ausführungsform zugrunde liegt.

### Ausführungsformen der Erfindung

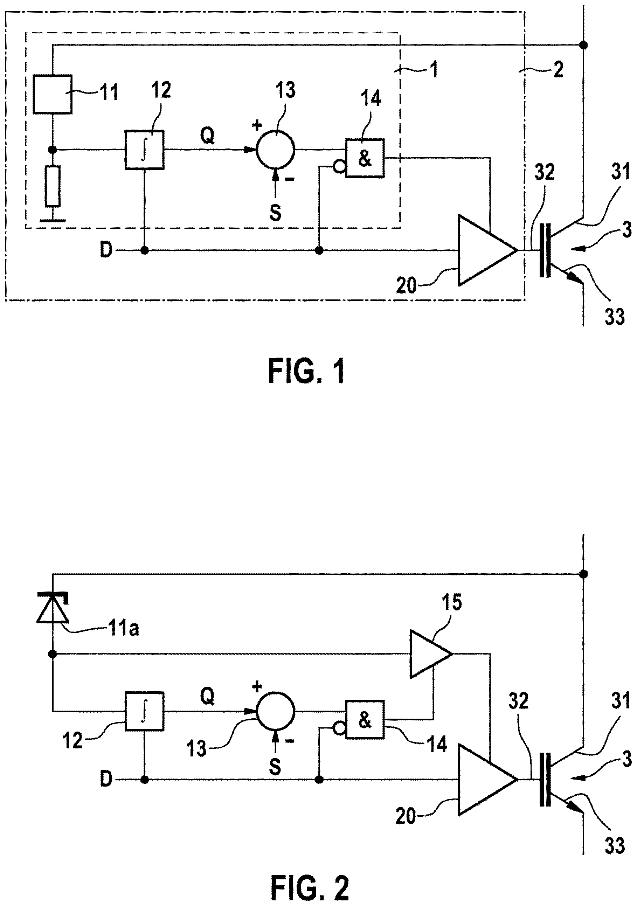

Figur 1 zeigt eine schematische Darstellung eines Prinzipschaltbilds einer Ansteuerschaltung 2 für einen Halbleiterschalter 3. Die Ansteuerschaltung 2 umfasst eine Treiberschaltung 20 zum Treiben des Steueranschlusses 32 des Halbleiterschalters 3. Die Treiberschaltung 20 empfängt hierzu ein Steuersignal D, verstärkt dieses Steuersignal D und steuert entsprechend dem Steuersignal D den Steueranschluss 32 des Halbleiterschalters 3 an. Auf diese Weise kann die elektrische Verbindung zwischen einem Eingangsanschluss 31 und einem Ausgangsanschluss 33 des Halbleiterschalters 3 geöffnet oder geschlossen werden. Beispielsweise kann es sich bei dem Halbleiterschalter 3 um einen MOSFET oder einen bipolaren Transistor mit einem isolierten Gateanschluss (IGBT) handeln. Selbstverständlich sind auch grundsätzlich beliebige andere Halbleiterschalter möglich. Beispielsweise kann es sich bei dem Halbleiterschalter 3 um einen Halbleiterschalter einer Leistungsstufe, wie zum Beispiel einem Stromrichter oder ähnlichem handeln. Wird die elektrische Verbindung zwischen dem Eingangsanschluss 31 und dem Ausgangsanschluss 33 des Halbleiterschalters 3 unterbrochen, so kann es zum Beispiel aufgrund von Streuinduktivitäten zu einem Spannungsanstieg zwischen dem

Eingangsanschluss 31 und dem Ausgangsanschluss 32 kommen. Steigt die elektrische Spannung zwischen dem Eingangsanschluss 31 und dem Ausgangsanschluss 32 über ein zulässiges Maß an, so kann der Halbleiterschalter 3 hierdurch beschädigt oder gegebenenfalls sogar zerstört werden. Zum Schutz vor solchen Überspannungen kann beispielsweise eine Schutzvorrichtung 1 vorgesehen sein.

Die Schutzvorrichtung 1 umfasst ein kapazitives Bauelement 11, einen Integrator 12 und eine Vergleichseinrichtung 13. Darüber hinaus kann die Schutzvorrichtung 1 beispielsweise auch ein Logikgatter 14 sowie gegebenenfalls auch weitere Komponenten umfassen. Das kapazitive Bauelement 11 ist zwischen dem Eingangsanschluss 31 des Halbleiterschalters und einem Eingangsanschluss des Integrators 12 angeordnet. Steigt die elektrische Spannung an dem Eingangsanschluss 31 des Halbleiterschalters 3, so wird das kapazitive Bauelement 11 über den Integrator 12 aufgeladen. Der Integrator 12 integriert dabei den Ladestrom in das kapazitive Bauelement. Durch diese Integration kann der Integrator 12 eine Ladungsmenge ermitteln, welche in das kapazitive Bauelement 12 hineinfließt. Bei konstanter Kapazität C des kapazitiven Bauelements 11 ist die Ladungsmenge in dem kapazitiven Bauelement 11 somit proportional zur elektrischen Spannung über dem kapazitiven Bauelement 11.

Der Integrator 12 gibt ein Ausgangssignal aus, welches proportional zu der ermittelten Ladungsmenge Q in dem kapazitiven Bauelement 11 ist. Hierbei kann es sich um ein analoges oder digitales Ausgangssignal handeln. Die ermittelte Ladungsmenge Q wird auf diese Weise einem Vergleicher 13 bereitgestellt. Der Vergleicher 13 vergleicht die ermittelte Ladungsmenge Q mit einem vorgegebenen Grenzwert S. Beispielsweise kann es sich bei dem Vergleicher 13 um einen Subtrahierer handeln, welcher eine Differenz zwischen der ermittelten Ladungsmenge Q und dem vorgegebenen Sollwert S bildet. Überschreitet die ermittelte Ladungsmenge Q den vorgegebenen Sollwert S, so kann daraufhin beispielsweise der Steuereingang 32 des Halbleiterschalters 3 angesteuert werden. Auf diese Weise kann der Halbleiterschalter 3 zwischen dem Eingangsanschluss 31 und dem Ausgangsanschluss 33 ganz oder zumindest teilweise leitend geschaltet werden. Hierdurch wird die elektrische Spannung zwischen dem Eingangsanschluss 31 und dem Ausgangsanschluss 32 verringert. Das Ansteuern des Steueranschlusses 32 des Halbleiterschalters 3 kann beispielsweise ebenfalls über die Treiberschaltung 20 erfolgen.

Darüber hinaus kann das Ansteuern des Halbleiterschalters 3 nach der Detektion des Überschreitens der ermittelten Ladungsmenge über den Sollwert S zusätzlich mit dem Ansteuersignal D verknüpft werden. Hierzu kann das Ergebnis des Vergleichers 13 und das Ansteuersignal D einem Logikgatter 14 zugeführt werden. Das Logikgatter 14 verknüpft das Ergebnis des Vergleichers 13 und das Ansteuersignal D miteinander. Beispielsweise kann der Halbleiterschalter 3 nur dann angesteuert werden, wenn entsprechend dem Steuersignal D der Halbleiterschalter nicht angesteuert werden sollte, jedoch der Vergleicher 13 ein Überschreiten der Ladungsmenge Q über den Sollwert S ermittelt. Solange das Ansteuersignal D ein aktives Ansteuern des Halbleiterschalters 3 vorgibt, erfolgt dagegen keine weitere Beeinflussung durch die Schutzvorrichtung 1.

Bei dem Integrator 12 kann es sich um einen beliebigen analogen oder digitalen Integrator handeln. Der Integrator 12 kann beispielsweise mittels einer beliebigen bekannten oder neuartigen Integratorschaltung realisiert werden.

Darüber hinaus kann die Integration des Integrators 12 mit dem Ansteuersignal D synchronisiert werden. Beispielsweise kann die Integration des Integrators 12 jeweils zurückgesetzt und neu gestartet werden, wenn entsprechend dem Ansteuersignal D der Halbleiterschalter 12 geöffnet werden soll. Auf diese Weise kann beispielsweise eine Drift des Integrators vermieden werden. Darüber hinaus ist selbstverständlich auch eine beliebige andere Synchronisation des Integrators 12, insbesondere unter Verwendung des Steuersignals D möglich.

Figur 2 zeigt eine schematische Darstellung eines Prinzipschaltbilds einer Ansteuerschaltung 2 für einen Halbleiterschalter 3 gemäß einer weiteren Ausführungsform. Die Ansteuerschaltung 2 und insbesondere die Schutzvorrichtung 1 entspricht dabei weitestgehend der zuvor beschriebenen Ausführungsform. Die Ausführungsform gemäß Figur 2 unterscheidet sich von der zuvor beschriebenen Ausführungsform insbesondere dadurch, dass es sich bei dem kapazitiven Bauelement 11 um eine Diode 11a handelt. Beispielsweise kann es sich bei der Diode 11a um eine Avalanche- oder Zener-Diode handeln. Eine solche Diode 11a kann eine definierte Durchbruchspannung aufweisen, bei welcher die Diode 11a auch in Sperrrichtung leitend wird. Bevor die Diode jedoch in den leitenden Zustand übergeht, weist die Diode 11a auch kapazitive Eigenschaften auf. Vor dem Durchbruch der Diode 11a erfolgt dabei ein Aufladen der Sperrschichtkapazität der Diode 11a. Der Integrator 12 integriert den Ladestrom in die Diode 11a und gibt entsprechend die ermittelte Ladungsmenge Q an den Vergleicher 13 weiter. Wird ein Überschreiten der Ladungsmenge Q über den vorgegebenen Sollwert S detektiert, so kann, wie zuvor bereits beschrieben, der Halbleiterschalter 3 angesteuert werden. Darüber hinaus kann auch ein Ansteuern des Halbleiterschalters 3 erfolgen, wenn die Diode 11a nach dem Überschreiten der Durchbruchspannung in einen leitenden Zustand übergeht. Hierzu ist der Anschluss der Diode 11a, welcher mit dem Integrator 12 verbunden ist, zusätzlich auch mit einer weiteren Treiberstufe 15 verbunden, die nach dem Durchbruch der Diode 11a ein Ausgangssignal zum Ansteuern des Halbleiterschalters 3 ausgibt. Ferner ist auch der Ausgang des Vergleichers 13, gegebenenfalls über das zuvor beschriebene Logikgatter 14, mit dieser weiteren Treiberstufe 15 verbunden. Auf diese Weise kann bei schnellen dynamischen Vorgängen ein Überspannungsschutz durch Auswerten der Ladungsmenge in der Diode 11a realisiert werden. Darüber hinaus kann auch bei langsamen, gegebenenfalls statischen Überspannungen ein Auslösen der Schutzvorrichtung durch Zünden der Diode 11a erreicht werden.

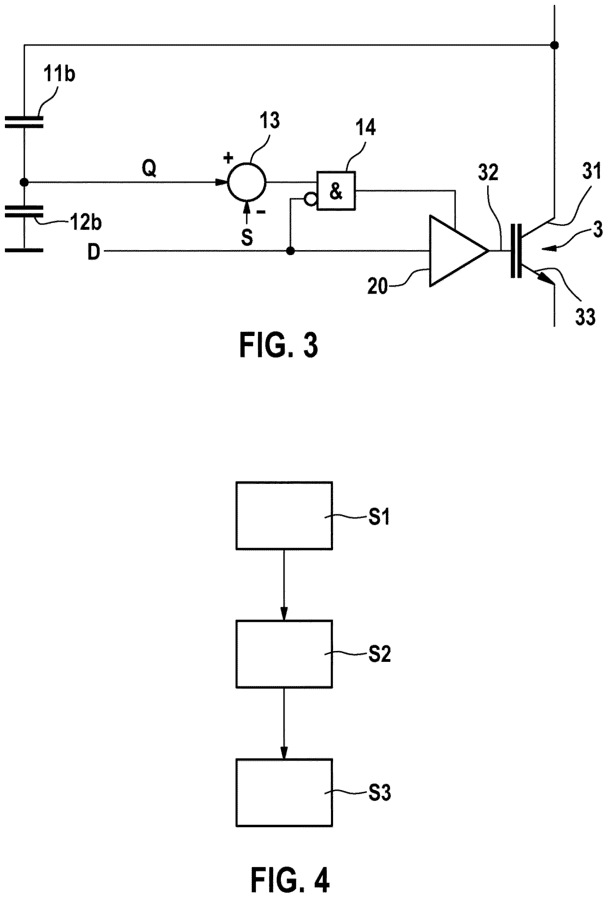

Figur 3 zeigt eine weitere Ausführungsform einer Ansteuerschaltung 2 für einen Halbleiterschalter. Bei dieser Ausführungsform umfasst das kapazitive Bauelement 11 einen Kondensator 11b. Entsprechend kann durch Integration des Ladestroms in den Kondensator 11b und einen Vergleich der Ladungsmenge aus dem integrierten Ladestrom mit einem Sollwert S ein Überspannungsschutz realisiert werden. Gegebenenfalls kann der Integrator 12 beispielsweise in einer einfachen Ausführungsform als Kondensator 12b realisiert werden. Eine derartige Schaltungsanordnung mit zwei Kondensatoren 11b und 12b als kapazitives Bauelement und Integrator ermöglicht einen besonders einfachen und somit kostengünstigen Überspannungsschutz für einen Halbleiterschalter 3.

Figur 4 zeigt eine schematische Darstellung eines Ablaufdiagramms, wie es einem Verfahren zum Ansteuern eines Halbleiterschalters 3 gemäß einer Ausführungsform zugrunde liegt. Das Verfahren kann grundsätzlich jede Art von geeigneten Verfahrensschritten umfassen, wie sie zuvor im Zusammenhang mit der Schutzvorrichtung 1 und der Ansteuerschaltung 2 bereits beschrieben wurden. Darüber hinaus kann auch die Schutzvorrichtung 1 und die Ansteuerschaltung 2 beliebige geeignete Komponenten umfassen, um die nachfolgend beschriebenen Verfahrensschritte zu realisieren.

Das Verfahren umfasst einen Schritt S1 zum Integrieren eines Ladestroms in ein kapazitives Bauelement 11. Das kapazitive Bauelement kann zwischen einem Eingangsanschluss 31 des Halbleiterschalters 3 und einem Integrator 12 angeordnet sein. Auf diese Weise kann aus dem integrierten Ladestrom eine Ladungsmenge Q in dem kapazitiven Bauelement 11 ermittelt werden. Das Verfahren umfasst ferner einen Schritt S2 zum Vergleichen der ermittelten Ladungsmenge Q in dem kapazitiven Bauelement mit einem vorgegebenen Grenzwert S. Schließlich umfasst das Verfahren einen Schritt S3 zum Ansteuern des Halbleiterschalters 3, wenn die ermittelte Ladungsmenge Q in dem kapazitiven Bauelement 11 den vorgegebenen Grenzwert S überschreitet.

Insbesondere kann die Integration des Ladestroms mit einem Steuersignal D für den Halbleiterschalter 3 synchronisiert werden. Beispielsweise kann die Integration des Ladestroms zurückgesetzt und gestartet werden, wenn der Halbleiterschalter 3 geschlossen wird.

Zusammenfassend betrifft die vorliegende Erfindung einen Schutz für einen Halbleiterschalter vor Überspannungen. Hierzu ist an einem Eingangsanschluss des Halbleiterschalters ein kapazitives Bauelement vorgesehen. Die Ladungsmenge, welche in dieses kapazitive Bauelement hineinfließt, wird integriert, um beim Überschreiten eines Grenzwertes eine Schutzfunktion auszulösen.

## Patentansprüche

1. Schutzvorrichtung (1) für einen Halbleiterschalter (3), mit:
einem kapazitiven Bauelement (11, 11a, 11b);
einem Integrator (12, 12b), der dazu ausgelegt ist, einen Ladestrom in das kapazitive Bauelement (11, 11a, 11b) zu integrieren, um aus dem integrierten Ladestrom eine Ladungsmenge (Q) in dem kapazitiven Bauelement (11, 11a, 11b) zu ermitteln; und
einer Vergleichseinrichtung (13), die dazu ausgelegt ist, den Halbleiterschalter (3) anzusteuern, wenn die ermittelte Ladungsmenge (Q) in dem kapazitiven Bauelement (11, 11a, 11b) einen vorgegebenen Grenzwert (S) überschreitet;
wobei das kapazitive Bauelement (11, 11a, 11b) zwischen einem Eingangsanschluss (31) des Halbleiterschalters (3) und dem Integrator (12, 12b) angeordnet ist.

2. Schutzvorrichtung (1) nach Anspruch 1, wobei das kapazitive Bauelement (11, 11a, 11b) eine Diode (11a), insbesondere eine Avalanche-Diode umfasst.

3. Schutzvorrichtung (1) nach Anspruch 2, wobei der vorgegebene Grenzwert (S) unter Verwendung einer Sperrschichtkapazität der Diode (11a) einstellbar ist.

4. Schutzvorrichtung (1) nach Anspruch 2 oder 3, wobei die Vergleichseinrichtung (13) dazu ausgelegt ist, den Halbleiterschalter (3) anzusteuern, wenn eine elektrische Spannung über der Diode (11a) eine Durchbruchspannung der Diode (11a) überschreitet.

5. Schutzvorrichtung (1) nach Anspruch 1, wobei das kapazitive Bauelement (11, 11a, 11b) einen Kondensator (11b) umfasst.

6. Schutzvorrichtung (1) nach einem der Ansprüche 1 bis 5, wobei der Integrator (12, 12b) dazu ausgelegt ist, die Integration des Ladestroms mit einem Steuersignal (D) für den Halbleiterschalter (3) zu synchronisieren.

7. Schutzvorrichtung (1) nach Anspruch 6, wobei der Integrator (12, 12b) dazu ausgelegt ist, die Integration des Ladestroms zu starten, wenn der Halbleiterschalter (13) geöffnet wird.

8. Schutzvorrichtung (1) nach einem der Ansprüche 1 bis 7, wobei der Integrator (12b) einen Kondensator umfasst.

9. Ansteuerschaltung (2) für eine Halbleiterschalter (3), mit:
einer Treiberschaltung (20), die dazu ausgelegt ist, ein Steuersignal (D) für den Halbleiterschalter (3) zu empfangen und einen Steueranschluss (32) des Halbleiterschalters (3) unter Verwendung des empfangenen Steuersignals (D) anzusteuern; und
einer Schutzvorrichtung (1) nach einem das Ansprüche 1 bis 8,
wobei die Treiberschaltung (20) mit der Schutzvorrichtung (1) elektrisch gekoppelt ist, und die Treiberschaltung (20) dazu ausgelegt ist, den Halbleiterschalter (3) zumindest teilweise anzusteuern, wenn die von der Schutzvorrichtung (1) ermittelte Ladungsmenge (Q) in dem kapazitiven Bauelement (11, 11a, 11b) den vorgegebenen Grenzwert (S) überschreitet.

10. Verfahren zum Ansteuern eines Halbleiterschalters (3), mit den Schritten:
Integrieren (S1) eines Ladestroms in ein kapazitives Bauelement (11, 11a, 11b), das zwischen einem Eingangsanschluss (31) des Halbleiterschalters (3) und einem Integrator (12, 12b) angeordnet ist, um aus dem integrierten Ladestrom eine Ladungsmenge (Q) in dem kapazitiven Bauelement (11, 11a, 11b) zu ermitteln;
Vergleichen (S2) der ermittelten Landungsmenge (Q) in dem kapazitiven Bauelement (11, 11a, 11b) mit einem vorgegebenen Grenzwert (S); und
Ansteuern (S3) des Halbleiterschalters (3), wenn die ermittelte Ladungsmenge (Q) in dem kapazitiven Bauelement (11, 11a, 11b) den vorgegebenen Grenzwert (S) überschreitet.

11. Verfahren nach Anspruch 10, wobei die Integration (S1) des Ladestroms gestartet wird, wenn der Halbleiterschalter (3) geöffnet wird.

## Claims

1. Protection device (1) for a semiconductor switch (3), having:
a capacitive component (11, 11a, 11b);
an integrator (12, 12b), which is designed to integrate a charging current into the capacitive component (11, 11a, 11b) in order to determine a quantity of charge (Q) in the capacitive component (11, 11a, 11b) from the integrated charging current; and
a comparison device (13), which is designed to control the semiconductor switch (3) when the determined quantity of charge (Q) in the capacitive component (11, 11 a, 11b) exceeds a preset limit value (S);
wherein the capacitive component (11, 11a, 11b) is arranged between an input terminal (31) of the semiconductor switch (3) and the integrator (12, 12b).

2. Protection device (1) according to Claim 1, wherein the capacitive component (11, 11a, 11b) comprises a diode (11a), in particular an avalanche diode.

3. Protection device (1) according to Claim 2, wherein the preset limit value (S) can be set using a junction capacitance of the diode (11a).

4. Protection device (1) according to Claim 2 or 3, wherein the comparison device (13) is designed to control the semiconductor switch (3) when an electrical voltage across the diode (11a) exceeds a breakdown voltage of the diode (11a).

5. Protection device (1) according to Claim 1, wherein the capacitive component (11, 11a, 11b) comprises a capacitor (11b).

6. Protection device (1) according to one of Claims 1 to 5, wherein the integrator (12, 12b) is designed to synchronize the integration of the charging current with a control signal (D) for the semiconductor switch (3).

7. Protection device (1) according to Claim 6, wherein the integrator (12, 12b) is designed to start the integration of the charging current when the semiconductor switch (13) is opened.

8. Protection device (1) according to one of Claims 1 to 7, wherein the integrator (12b) comprises a capacitor.

9. Control circuit (2) for a semiconductor switch (3), having:
a driver circuit (20), which is designed to receive a control signal (D) for the semiconductor switch (3) and to control a gate (32) of the semiconductor switch (3) using the received control signal (D); and
a protection device (1) according to one of Claims 1 to 8,
wherein the driver circuit (20) is electrically coupled to the protection device (1), and the driver circuit (20) is designed to control the semiconductor switch (3) at least partially when the quantity of charge (Q) in the capacitive component (11, 11a, 11b) determined by the protection device (1) exceeds the preset limit value (S).

10. Method for controlling a semiconductor switch (3), having the following steps:
integrating (S1) a charging current into a capacitive component (11, 11a, 11b), which is arranged between an input terminal (31) of the semiconductor switch (3) and an integrator (12, 12b), in order to determine a quantity of charge (Q) in the capacitive component (11, 11a, 11b) from the integrated charging current;
comparing (S2) the determined quantity of charge (Q) in the capacitive component (11, 11a, 11b) with a preset limit value (S); and
controlling (S3) the semiconductor switch (3) when the determined quantity of charge (Q) in the capacitive component (11, 11a, 11b) exceeds the preset limit value (S).

11. Method according to Claim 10, wherein the integration (S1) of the charging current is started when the semiconductor switch (3) is opened.

## Revendications

1. Dispositif de protection (1) destiné à un commutateur à semi-conducteur (3), ledit dispositif de protection comprenant :
un composant capacitif (11, 11a, 11b) ;
un intégrateur (12, 12b) qui est conçu pour intégrer un courant de charge dans le composant capacitif (11, 11a, 11b) afin de déterminer une quantité de charge (Q) dans le composant capacitif (11, 11a, 11b) à partir du courant de charge intégré ; et
un module de comparaison (13) qui est conçu pour commander le commutateur à semi-conducteur (3) lorsque la quantité de charge (Q) déterminée dans le composant capacitif (11, 11a, 11b) devient supérieure à une valeur limite spécifiée (S) ;
le composant capacitif (11, 11a, 11b) étant disposé entre une borne d'entrée (31) du commutateur à semi-conducteur (3) et l'intégrateur (12, 12b).

2. Dispositif de protection (1) selon la revendication 1, le composant capacitif (11, 11a, 11b) comprenant une diode (11a), en particulier une diode à avalanche.

3. Dispositif de protection (1) selon la revendication 2, la valeur limite spécifiée (S) pouvant être réglée à l'aide d'une capacité de transition de la diode (11a).

4. Dispositif de protection (1) selon la revendication 2 ou 3, le module de comparaison (13) étant conçu pour commander le commutateur à semi-conducteur (3) lorsqu'une tension électrique aux bornes de la diode (11a) devient supérieure à une tension de claquage de la diode (11a).

5. Dispositif de protection (1) selon la revendication 1, le composant capacitif (11, 11a, 11b) comprenant un condensateur (11b).

6. Dispositif de protection (1) selon l'une des revendications 1 à 5, l'intégrateur (12, 12b) étant conçu pour synchroniser l'intégration du courant de charge avec un signal de commande (D) destiné au commutateur à semi-conducteur (3).

7. Dispositif de protection (1) selon la revendication 6, l'intégrateur (12, 12b) étant conçu pour démarrer l'intégration du courant de charge lors de l'ouverture du commutateur à semi-conducteur (13).

8. Dispositif de protection (1) selon l'une des revendications 1 à 7, l'intégrateur (12b) comprenant un condensateur.

9. Circuit de commande (2) destiné à un commutateur à semi-conducteur (3), ledit circuit de commande comprenant :
un circuit d'attaque (20) qui est conçu pour recevoir un signal de commande (D) destiné au commutateur à semi-conducteur (3) et pour commander une borne de commande (32) du commutateur à semi-conducteur (3) à l'aide du signal de commande (D) reçu ; et
un dispositif de protection (1) selon l'une des revendications 1 à 8,
le circuit d'attaque (20) étant couplé électriquement au dispositif de protection (1), et le circuit d'attaque (20) étant conçu pour commander au moins partiellement le commutateur à semi-conducteur (3) lorsque la quantité de charge (Q) déterminée par le dispositif de protection (1) dans le composant capacitif (11, 11a, 11b) devient supérieure à la valeur limite spécifiée (S).

10. Procédé de commande d'un commutateur à semi-conducteur (3), ledit procédé comprenant les étapes suivantes :
intégrer (S1) un courant de charge dans un composant capacitif (11, 11a, 11b), qui est disposé entre une borne d'entrée (31) du commutateur à semi-conducteur (3) et un intégrateur (12, 12b), afin de déterminer une quantité de charge (Q) dans le composant capacitif (11, 11a, 11b) à partir du courant de charge intégré ;
comparer (S2) la quantité de charge déterminée (Q) dans le composant capacitif (11, 11a, 11b) à une valeur limite spécifiée (S) ; et
commander (S3) le commutateur à semi-conducteur (3) lorsque la quantité de charge (Q) déterminée dans le composant capacitif (11, 11a, 11b) devient supérieure à la valeur limite spécifiée (S).

11. Procédé selon la revendication 10, l'intégration (S1) du courant de charge démarrant lors de l'ouverture du commutateur à semi-conducteur (3).
